# EUROPÄISCHE PATENTSCHRIFT

(11) **EP 2 320 244 B1**
(45) Veröffentlichungstag und Bekanntmachung des Hinweises auf die Patenterteilung: **03.12.2014**
(21) Anmeldenummer: 10189491.3
(22) Anmeldetag: 29.10.2010
(51) Int. Cl.: G01R 33/31, G01R 33/34

(54) **Kühlvorrichtung zur kryogenen Kühlung eines NMR-Detektionssystems mit Hilfe eines mit kryogenem Fluid gefüllten Behälters**
Cooling device for cryogenic cooling of an NMR detection system with the help of a container filled with cryogenic fluid
Dispositif de refroidissement pour le refroidissement cryogène d'un système de détection RMN à l'aide d'un récipient rempli de fluide cryogène

(30) Priorität: 03.11.2009 DE 102009046321
(43) Veröffentlichungstag der Anmeldung: 11.05.2011
(73) Patentinhaber: Bruker BioSpin AG, 8117 Fällanden (CH)
(72) Erfinder: Schnell, Marc, 8050 Zürich (CH); Paredes, Marc Enrique, 8038 Zürich (CH); Cetrefli, Cengiz, 8053 Zürich (CH); Stauffenegger, Philippe, 8600 Dübendorf (CH); Marek, Daniel, 5103 Möriken (CH)
(74) Vertreter: Kohler Schmid Möbus

(56) Entgegenhaltungen:
- DE-A1- 10 340 352
- JP-A- 2008 046 008
- US-A1- 2007 096 740

## Beschreibung

### Hintergrund der Erfindung

Die Erfindung betrifft einen Kryo-Probenkopfkopf zum Senden und/oder Empfangen von Hochfrequenz-Signalen für Kernspinresonanz-Messungen, mit mindestens einem Wärmetauscher zur Kühlung einer oder mehrerer Wärmequellen, insbesondere Bauelementen des Kryo-Probenkopfes, wobei dem Wärmetauscher kryogenes Fluid zugeführt wird und der Wärmetauscher mindestens ein Kontaktelement aufweist, das eine thermisch gut leitende Verbindung zwischen dem kryogenen Fluid und der Wärmequelle gewährleistet.

Eine solche Anordnung ist bekannt aus DE 103 40 352 A1.

Bei einer Anordnung zur Messung mit Hilfe der Kernspinresonanz befindet sich im starken stationären Magnetfeld eines typischerweise supraleitenden Magneten ein sogenannter Probenkopf. In diesen wird die zu messende Probe eingeführt. Der Probenkopf beinhaltet Hochfrequenz-Spulen bzw. Resonatoren, die einerseits zum Anregen der Kernspins dienen wie auch die von den angeregten Kernspins erzeugten Signale empfangen. Da die Kernspinsignale im Allgemeinen sehr schwach sind, werden sie leicht von Störungen überlagert. Daher ist das Signal-zu-Rausch-Verhältnis (S/N) bei der Kernspinresonanz ein sehr wichtiges Leistungskriterium. Ein gängiges Vorgehen das S/N-Verhältnis zu verbessern, ist die Kühlung der relevanten Bauelemente auf möglichst niedrige Temperaturen. Dabei handelt es sich um sogenannte Kryo-Probenköpfe.

Um Kryo-Probenköpfe auf kryogene Temperaturen abzukühlen werden im Allgemeinen Kältemaschinen mit geschlossenen Gaskreisläufen, vorzugsweise mit Helium als Fluid verwendet, basierend auf Gifford-McMahon-, Stirling- oder Joule-Thomson-Prozessen.

Eine weitere Kühlmethode ist das Verdampfen von kryogenen Flüssigkeiten innerhalb des Probenkopfes. Flüssiges Fluid wird durch Leitungen in den Probenkopf geleitet, wo es unter Einwirkung der Wärmelast verdampft.

Merkmal jeglicher Kühlmechanismen ist ein Fluid, das die notwendige Kühlleistung bereitstellt zur Wärmeabfuhr und eine thermische Kontaktierung, welche den Transport von Wärme von der zu kühlenden Komponente zum Wärmetransportmedium=Fluid hin ermöglicht. Im Allgemeinen wird eine solche Vorrichtung als Wärmetauscher bezeichnet.

Unabhängig von der Charakteristik eines Kühlsystems und dessen Hilfsaggregaten muss ein NMR-Detektionssystem möglichst störungsfrei mit geringen Betriebs- und Wartungskosten betrieben werden können.

Die vorliegende Erfindung behandelt im Folgenden den Aspekt der Kühlung von Komponenten eines NMR-Detektionssystems mit dem Ziel einer möglichst einfachen und effizienten Kühlung unter minimalem Aufwand, und minimaler Anfälligkeit auf systeminterne und systemexterne Störungen.

Der Betrieb von Kältemaschinen erfordert eine Anzahl von Hilfsaggregaten wie Kompressoren, Kühler, Pumpen usw., was die Installation und den Betrieb entsprechend aufwändig macht, sowohl hinsichtlich des Wartungsaufwands, als auch hinsichtlich der Betriebskosten. Des Weiteren können aufgrund von rotierenden oder linear bewegten Komponenten in den Aggregaten mechanische Vibrationen auf den Probenkopf übertragen werden. Mechanische Vibrationen, die auf den Probenkopf übertragen werden, können das NMR-Signal in erheblichem Maße negativ beeinflussen.

Nach gängigem Stand der Technik wird ein Wärmetauscher über einen Zufluss mit einem gasförmigen oder flüssigen Kühlfluid versorgt, welches einen Wärmetauscher über einen Abfluss wieder verlässt. Über ein thermisch gut leitendes Kontaktelement ist ein Wärmetauscher mit einer Wärmequelle verbunden, wobei letztere durch Abfuhr einer gewissen Wärmelast auf einer gewünschten Temperatur gehalten wird. Die Wärmequelle kann beispielsweise ein HF-Resonator oder ein Signalverstärker sein.

Die Verbindungen zwischen Zufluss und Abfluss sind in erhältlichen Systemen als Kühlkanäle ausgeführt, die in der thermischen Kontaktierung über beliebig verlaufende Strukturen den Durchfluss eines Fluids und die Übertragung von Wärme von einer Wärmequelle an ein Kühlfluid ermöglichen. Die Kühlleitungen können schraubenartig um eine thermische Kontaktierung herum verlaufen, oder spiralförmig in die thermische Kontaktierung eingearbeitet sein. Andere Ausführungen der Kühlkanäle sind ebenfalls möglich.

Sowohl die Kühlung durch Verdampfung eines flüssigen Kryogens als auch die Kühlung durch kryogene Gase in Kältemaschinen werden bei handelsüblichen NMR-Detektionssystemen eingesetzt, wobei bei Systemen nach dem Stand der Technik erhebliche Nachteile auftreten.

Die Kühlung von Kryo-Probenköpfen mit Hilfe von in Kältemaschinen umgesetzten thermodynamischen Kreisprozessen ist in DE 103 403 52 A1 oder US 5,508,613 A erwähnt.

Die Kühlung durch Verdampfung von flüssigem Helium oder Stickstoff innerhalb eines Kryo-Probenkopfes ist in EP 0 782 005 A1 beschrieben. In JP-A-2008 046008 wird ebenfalls die Kühlung von Resonatorspulen im Probenkopf mittels eines von Flüssigphase oder Gasphase durchströmten Behälters beschrieben.

Der Vorteil der Kühlung durch Verdampfung eines Fluids ist, dass durch den Phasenwechsel von der flüssigen Phase zur gasförmigen Phase bei einem konstanten Druck zum einen der Umgebung ein Maximum an Wärme entzogen wird und somit eine gasabhängige minimale Temperatur erreicht wird, zum anderen dass die Temperatur beider Phasen des Fluids während des Phasenwechsels konstant bleibt. Die maximale Kühlwirkung bei minimalem Kühlmittelverbrauch wird dann erreicht, wenn am Austritt des Kühlsystems der Anteil an flüssigem Kryogen gleich Null ist.

Bei der Verdampfungskühlung kann durch den Phasenübergang eine extreme Dichteänderung des Fluids innerhalb des Kühlsystems entstehen, wodurch das Fluid in Leitungen eine Geschwindigkeitsänderung erfahren und es dadurch zur Ausbildung von Druckwellen bzw. zu thermoakustischen Vibrationen kommen kann, die durch das System wandern und zu mechanischen Vibrationen führen können. Desweiteren können bei kryogenen Flüssigkeiten 2-Phasen-Strömungen auftreten, die in engem Zusammenhang mit Strömungs-Instabilitäten stehen, die Druckschwankungen bewirken.

Die Problematik der Zwei-Phasenströmung eines kryogenen Fluids in einer Rohrleitung, der damit verbundenen instabilen Zustände und deren Auswirkung auf die Wärmeübertragungseigenschaften wurde von Qi et al im International Journal of Heat and Mass Transfer (Vol. 50, Issue 25/26, Seite 4999-5016) diskutiert.

Abhängig von der übertragenen Wärmemenge pro Zeiteinheit (=Wärmestrom) und dem Wärmestrom pro Fläche (=Wärmestromdichte), kommt es zu Änderungen des Siedezustands der Flüssigkeit, z.B. wechselt die Wärmeübertragung durch reine Konvektion zum Zustand des Blasensiedens. Als Folge davon werden periodische Druckschwankungen, Wandtemperaturschwankungen und Schwankungen des übertragbaren Wärmestroms beobachtet.

Blasensieden ist im Rohrleitungssystem nicht erwünscht, weil die entstehenden Gasblasen in der gesamten Leitung weitergeführt werden müssen und der Druckverlust mit steigendem Gasanteil zunimmt. Im Gegensatz dazu ist Blasensieden sehr wohl wünschenswert, weil durch den erhöhten Stofftransport durch sich von den Leitungswänden ablösende Gasblasen im Fluid eine höhere Wärmestromdichte übertragbar ist und somit eine höhere Kühlleistung erreicht wird.

Eine mit kryogener Flüssigkeit gekühlte NMR-HF-Spule wurde von Styles et al. im Journal of Magnetic Resonance (Vol. 60, Seiten 397-404, 1984) beschrieben. In dem dort beschriebenen Aufbau ist die HF-Spule als Röhrchen ausgebildet und wird von einem kryogenen Fluid durchströmt. Innerhalb der Spule kommt es unter Einwirkung der thermischen Leistung der HF-Spule zur Verdampfung des Fluids und somit zur Kühlung der HF-Spule. Ein solcher Aufbau ist allerdings mit erheblichen Nachteilen verbunden. Die Formgestaltung der Spule dürfte stark eingeschränkt sein, wenn sie als Röhrchen ausgebildet sein muss. Bei der Verdampfung und der damit verbundenen rapiden Dichteänderung wird die Strömung der Gasphase stark beschleunigt. Da die Konstruktion keine Phasentrennung vorsieht wird sich die Dichteänderung in Form von thermoakustischen Schwingungen auf die Flüssigphase und die gesamte Fluidförderung auswirken. Das unter Druck durch die Spule gepresste kryogene Fluid bewirkt Vibrationen, wodurch Suszeptibilitätsänderungen in der Spule und mechanische Schwingungen entstehen können.

In DE 40 13 111 A1 ist ein System beschrieben, bei dem die Spule nicht in direktem Kontakt mit dem kryogenen Fluid steht, sondern über eine wärmeleitende Verbindung damit verbunden ist. Allerdings besteht trotz der räumlichen Trennung der Funktionen "Kühlung" und "HF-Empfang" prinzipiell auch weiterhin das Problem der Vibrationen, da weiterhin kryogenes Fluid an die wärmeleitende Verbindung gefördert werden muss und die Problematik der Vibrationen in den Fluidleitungen weiterhin besteht.

Die Verwendung von flüssigem Helium zur Spulenkühlung ist explizit in JP 2008 241 493 A und WO 03/023433 A1 erwähnt. In beiden Quellen wird flüssiges Helium durch ein Röhrchen von unten in einen Wärmetauscher eingeleitet. Störungen in der Fluidförderung setzen sich somit bis in den Wärmetauscher ungedämpft fort. Durch den Zufluss von unten müssen die in der Zuflussleitung auftretenden Gasblasen beim Eintreten in den Wärmetauscher das gesamte Flüssigkeitsbad durchströmen und führen dadurch zu sehr unruhigem Sprudeln des Flüssigkeitspegels und bewirken erhebliche mechanische Vibrationen. Eine weitere Schwachstelle ist zudem die nicht in hinreichendem Masse oder gar nicht einstellbare Pegelhöhe des flüssigen Kryogens und die zeitlich nicht konstante Kühlleistung.

Dies ist vor allem in WO 03/023433 A1 und in JP-A-2008 046008 problematisch, wo das den Wärmetauscher verlassende Fluid nach unten abgeleitet wird. Hier könnte es im Extremfall zu einem sequentiellen Befüllen und vollständigem Entleeren des Wärmetauschers kommen, wenn sich über dem Abfluss ein Flüssigkeitsbad bildet, den Abfluss dadurch blockiert und ein abgeschlossenes Gasvolumen im Wärmetauscher ausgebildet wird. Das entstehende Gas kann nicht abströmen und bewirkt einen Druckanstieg, welcher der Strömung im Zufluss entgegenwirkt, und gleichzeitig Flüssigkeit aus dem Abfluss herauspresst. Im Extremfall können zu 100% Flüssigkeit in den Abfluss gefördert werden. Die Folge hiervon wäre ein vollständiges Entleeren des Wärmetauschers, bis der Druck soweit abgesunken ist, dass ein erneutes Befüllen durch den Zufluss möglich ist.

Die Notwendigkeit der thermischen Entkopplung mehrerer HF-Spulen untereinander ist in DE 103 40 352 A1 diskutiert. Bei der dort beschriebenen Vorrichtung wird pro Spule jeweils ein separater, mit gasförmigem Fluid durchströmter Wärmetauscher verwendet, was einer kompakten Bauweise entgegensteht. Ferner wird bei der vorgeschlagenen Gaskühlung für NMR-Detektoren bei einer Serienschaltung der Zufluss in einen Wärmetauscher immer wärmer sein als der Zufluss im vorangegangenen Wärmetauscher. Um eine Temperatur auf dem gleichen Niveau zu erreichen ist die Verwendung einer aktiven Regelung notwendig.

### Kurze Beschreibung der Erfindung

Aufgabe der vorliegenden Erfindung ist es demgegenüber, in einer NMR-Detektionsvorrichtung den NMR-Resonator sowie diverse Bauelemente mittels Verdampfung eines kryogenen Fluids auf kryogene Temperaturen zu kühlen und dabei den Einfluss von Vibrationen, die durch den Kühlvorgang entstehen können und sich störend auf das NMR-Signal auswirken, weitgehend zu reduzieren. Zusätzlich soll insbesondere der Verbrauch des kryogenen Fluids so gering wie möglich gehalten werden.

Diese Aufgabe wird erfindungsgemäß auf ebenso überraschend einfache wie wirkungsvolle Weise dadurch gelöst, dass der Wärmetauscher einen als Pufferreservoir für das kryogene Fluid wirkenden Behälter mit einem Innenvolumen V_{B} umfasst, welcher eine erste Öffnung aufweist, durch die über eine Zuflussleitung (8) des Wärmetauschers ein erstes kryogenes Fluid F₁ hineinfließen kann, das einen flüssigen Anteil F_{1L} und einen gasförmigen Anteil F_{1G} aufweist, , und welcher eine zweite Öffnung aufweist, durch welche über eine Abflussleitung (9) des Wärmetauschers ein zweites kryogenes Fluid F₂ herausfließen kann, das einen flüssigen Anteil F_{2L} und einen gasförmigen Anteil F_{2G} aufweist, dass die Zuflussleitung einen Durchflussquerschnitt Q_{Z} und einen Umfang U_{Z} aufweist, aus denen sich ein hydraulischer Durchmesser D_{hyd,Z}=4·Q_{Z}/U_{Z} und daraus ein charakteristisches Leitungsvolumen V_{Z}=Q_{Z}·D_{hyd,Z} ergibt, wobei der Behälter im Verhältnis zur Zuflussleitung so beschaffen ist, dass V_{B}>10·V_{Z}, dass die Abflussleitung einen Durchflussquerschnitt Q_{A} aufweist, der so gewählt ist, dass Q_{A}≥Q_{Z}, dass das Kontaktelement sowohl mit dem flüssigen Volumenanteil V_{L} des kryogenen Fluids im Behälter als auch mit der Wärmequelle in engem thermischen Kontakt steht, dass die Öffnungen der Zuflussleitung (8) und der Abflussleitung (9) so weit oberhalb der unteren Wand des Behälters angeordnet sind, dass der flüssige Volumenanteil VL nicht vollständig aus dem Behälter abfließen kann, und dass eine Vorrichtung zur Einstellung der Zuflussmenge des ersten kryogenen Fluids F₁ in den Behälter vorgesehen ist, die es ermöglicht, dass im Betrieb des Kryo-Probenkopfes ein Zustand erreicht und gehalten wird, bei welchem gilt: F_{1L}/F_{1G} > F_{2L}/F_{2G}.

Durch das große Innenvolumen V_{B} und die darin enthaltenen gasförmigen Volumenanteile V_{G} können im Zufluss eventuell auftretende Druckwellen durch Komprimieren des gasförmigen Volumenanteils V_{G} aufgefangen werden, insbesondere, da V_{B} deutlich größer ausgeführt ist, als das charakteristische Leitungsvolumen V_{Z}. Zusätzlich dient der flüssige Volumenanteil V_{L} im Behälter als Reserve, falls es kurzzeitig zu einem, für die abzuführende Wärmemenge nicht ausreichenden, Zufluss von Kühlmittel kommen sollte. Durch den Vorrat an flüssigem Volumen V_{L} kann die Temperatur der Wärmequelle konstant gehalten werden. Durch die großzügige Dimensionierung der Abflussleitung wird ein Rückstau des abzuführenden Abflusses aus dem Behälter verhindert und somit der Entstehung von Druckwellen im Abfluss und mechanischen Vibrationen vorgebeugt. Dadurch, dass sich das Kontaktelement in engem thermischen Kontakt mit dem flüssigen Volumenanteil V_{L} befindet, wird sichergestellt, dass der Wärmestrom nahezu vollständig durch Sieden übertragen wird, während eine eventuelle Wärmekonvektion durch den gasförmigen Anteil V_{G} bei den bei einer erfindungsgemäßen Vorrichtung typischen Strömungsgeschwindigkeiten des kryogenen Fluids vernachlässigbar klein ist. Dadurch sind die Position und das Ausmaß der Wärmeabgabe genau definiert und zeitlich konstant. Instabile und instationäre Strömungszustande in der Zuflussleitung und daraus entstehende thermoakustische Oszillationen, mit denen bei der Förderung kryogener Fluide zu rechnen ist, werden in der erfindungsgemäßen Vorrichtung gedämpft und abgeschwächt und deren negative Beeinflussung des NMR-Signals minimiert. Durch die Regelung der Zuflussmenge wird erreicht, dass der Zustand und somit auch die damit zusammenhängenden vorteilhaften Effekte in dem Behälter weitestgehend konstant bleiben.

Bei einer besonders bevorzugten Ausführungsform der erfindungsgemäßen Vorrichtung werden der Behälter und die Zuflussleitung so gestaltet, dass gilt V_{B}>20·V_{Z}, vorzugsweise 70·V_{Z}≤ V_{B}≤150·V_{Z}. Diese Werte haben sich in der Praxis bewährt.

Bei einer weiteren vorteilhaften Ausführung ist eine Regelvorrichtung vorgesehen, welche die Vorrichtung zur Einstellung der Zuflussmenge des ersten kryogenen Fluids F₁ in den Behälter ansteuert und den Volumenanteil V_{L} an flüssigem kryogenen Fluid im Behälter im Verhältnis zum Volumenanteil V_{G} an gasförmigem kryogenen Fluid auf einen vorgebbaren Wert regelt. Das Verhältnis zwischen V_{L} und V_{G} hat wesentlichen Einfluss auf die Stabilität der Kühlung und die Dämpfung von ungewünschten Vibrationen. Es ist daher von großem Vorteil, mittels eines Regelmechanismus auf dieses Verhältnis Einfluss nehmen zu können. Idealerweise weist diese Ausführungsform der erfindungsgemäßen Vorrichtung einen Pegel-Sensor zur Messung des aktuellen Pegelstands des Volumenanteils V_{L} an flüssigem kryogenen Fluid im Behälter auf. Mit Hilfe des Messwerts dieses Pegel-Sensors wird die Regelung des Verhältnisses von V_{G} und V_{L} vereinfacht. Alternativ kann auch ein Sensor in der Abflussöffnung 9 angeordnet. Dieser Sensor detektiert dann, ob im Abfluss F₂ 3 ein Flüssiganteil F_{2L} vorliegt. Ist der Flüssiganteil F_{2F} größer als Null, so wird die Regelvorrichtung den Zufluss F₁ 2 reduzieren.

Vorteilhaft ist es, wenn bei der oben beschriebenen Ausführungsform die Regelvorrichtung die Zuflussmenge des ersten kryogenen Fluids F₁ in den Behälter, insbesondere in Abhängigkeit von der durch die Wärmequellen über das Kontaktelement an den Wärmetauscher abgegebenen Wärmemenge, so regelt, dass V_{G}>V_{L}, vorzugsweise V_{G}≥5·V_{L}. Diese Verhältnisse sind besonders wünschenswert im Bezug auf die oben genannten Eigenschaften des Verhältnisses von V_{G} zu V_{L},

Optimalerweise regelt die Regelvorrichtung der zwei oben erwähnten Ausführungsvarianten die Zuflussmenge des ersten kryogenen Fluids F₁ in den Behälter so, dass F_{2L}≈0. Auf diese Weise wird der Verbrauch an kryogener Flüssigkeit auf einfache Weise minimiert.

Bei einer besonders bevorzugten Variante der 3 zuletzt beschriebenen Ausführungsformen ist ein Temperatursensor zur Messung der Temperatur der Wärmequelle vorgesehen, dessen Ausgangssignal der Regelvorrichtung als Eingangssignal zur Regelung der Zuflussmenge des ersten kryogenen Fluids F₁ in den Behälter zugeführt wird. Auf diese Weise lässt sich eine konstante Temperatur der Wärmequelle auf besonders einfache Weise realisieren.

Bei einer optimierten Variante der zuvor beschriebenen Ausführungsformen wird über die Vorrichtung zur Einstellung der Zuflussmenge des ersten kryogenen Fluids F₁ in den Behälter der Fluidzufluss erhöht, sobald die Unterschreitung eines vorgebbaren Pegelstands gemeldet wird. Auf diese Weise muss die Zuflussmenge des ersten kryogenen Fluids F₁ nicht manuell eingestellt und überwacht werden.

Bei einer weiteren Variante der vorletzten Ausführungsform wird über die Vorrichtung zur Einstellung der Zuflussmenge des ersten kryogenen Fluids F₁ in den Behälter der Fluidzufluss bei Erreichen oder Überschreiten eines maximalen Flüssigkeitspegels abgesperrt und bei Erreichen oder Unterschreiten eines minimalen Flüssigkeitspegels der Fluidzufluss wieder zugeschaltet. Auf diese Weise wird vermieden, dass der Flüssigkeitspegel manuell überwacht und eingestellt werden muss. Dies vereinfacht die Bedienung der erfindungsgemäßen Vorrichtung in erheblicher Weise.

Eine bevorzugte Ausführungsform weist eine Temperaturregelung der Wärmequelle mit Hilfe einer Regelvorrichtung und eines Heizers auf, der mit der Wärmequelle thermisch gut verbunden ist, wobei die geregelte Temperatur zwingend immer höher ist, als die Temperatur, die ohne Heizer erreicht wird. Dadurch läßt sich auf einfache aber wirkungsvolle Weise bei einem Anstieg der Wärmelast an der Wärmequelle die Temperatur auf einen konstanten Wert regeln.

Bei einer besonderes bevorzugten Ausführungsform ist die Wärmequelle, direkt an der unteren Wand des zum Wärmetauscher gehörenden Behälters angeschlossen, wobei diese untere Wand die Funktion des Kontaktelementes übernimmt und deshalb vorzugsweise aus einem Material mit einem möglichst kleinen thermischen Widerstand und einer Wandstärke, die möglichst klein ist, aufgebaut ist, so dass auf diese Weise eine möglichst gute thermische Verbindung zwischen der Wärmequelle und dem flüssigen Fluid V_{L} gewährleistet ist. Dies ist besonders vorteilhaft, weil dadurch Material für ein gesondertes Kontaktelement eingespart werden kann.

Eine weitere bevorzugte Ausführungsform weist eine Wärmequelle auf, welche direkt an der oberen Wand des zum Wärmetauscher gehörenden Behälters angeschlossen ist, wobei die obere und die seitlichen Wände dieses Behälters die Funktion des Kontaktelementes übernehmen und deshalb vorzugsweise aus einem Material mit einem möglichst kleinen thermischen Widerstand und einer Wandstärke, die möglichst groß ist, aufgebaut sind, so dass auf diese Weise eine möglichst gute thermische Verbindung zwischen der Wärmequelle und dem flüssigen Fluid V_{L} gewährleistet ist. Wie bei der vorstehenden Ausführungsform kann auch hier ein separates Kontaktelement eingespart werden.

Bei einer weiteren zu bevorzugenden Ausführungsform einer erfindungsgemäßen Vorrichtung ist die Wärmequelle direkt an der oberen Wand des zum Wärmetauscher gehörenden Behälters angeschlossen, und dieser Behälter enthält zudem in seinem Innern ein thermisch gut leitendes Kontaktelement, das mit der oberen Wand des Behälters fest verbunden und in das flüssige Fluid V_{L} eingetaucht ist, wobei das Kontaktelement vorzugsweise direkt unterhalb der Wärmequelle angeordnet ist und die obere Wand vorzugsweise eine möglichst kleine Wandstärke besitzt, so dass auf diese Weise eine möglichst gute thermische Verbindung zwischen der Wärmequelle und dem flüssigen Fluid V_{L} gewährleistet ist. Bei dieser Ausführungsform ist die Kontaktfläche zwischen dem flüssigen Anteil des Fluids V_{L} und dem Kontaktelement besonders groß, was vorteilhafterweise die Blasenbildung in der flüssigen Phase verringert.

Eine weitere vorteilhafte Ausführungsform weist einen Wärmetauscher mit einem Kontaktelement auf, das oben aus dem Wärmetauscher ragt, an der oberen Wand des Wärmetauschers befestigt ist und eine gute thermische Verbindung zur Wärmequelle besitzt, wobei der untere Teil des Kontaktelements im flüssigen Fluid V_{L} eingetaucht ist, so dass auf diese Weise eine möglichst gute thermische Verbindung zwischen der Wärmequelle und dem flüssigen Fluid V_{L} gewährleistet ist. Diese Variante kann sich vorteilhaft auswirken, da die Wärmequelle hier keinen direkten Kontakt zum Behälter der Wärmetauschers hat und eine Erwärmung desselbigen minimiert werden kann.

Bei einer alternativen Ausführungsform ist die Wärmequelle an der seitlichen Wand des zum Wärmetauscher gehörenden Behälters oberhalb des Fluidpegels befestigt, wobei diese Wand die Funktion des Kontaktelementes übernimmt und deshalb vorzugsweise aus einem Material mit einem möglichst kleinen thermischen Widerstand und einer Wandstärke, die möglichst groß ist, aufgebaut ist.

Bei einer dem ähnlichen, alternativen Ausführungsform ist die Wärmequelle an der seitlichen Wand des zum Wärmetauscher gehörenden Behälters unterhalb des Fluidpegels befestigt ist, wobei diese Wand die Funktion des Kontaktelementes übernimmt und deshalb vorzugsweise aus einem Material mit einem möglichst kleinen thermischen Widerstand und einer Wandstärke, die möglichst klein ist, aufgebaut ist.

Optimalerweise ist das Kontaktelement, mit einem thermisch isolierenden Befestigungselement verbunden, wobei dieses Befestigungselement derart gestaltet ist, dass der obere Teil des Kontaktelements vom flüssigen Fluid V_{L} abgetrennt wird, und nur der untere Teil im Fluid V_{L} eingetaucht bleibt, so dass auf diese Weise die Temperatur der Wärmequelle weniger von Änderungen des Pegels von V_{L} beeinflusst wird. Diese Ausführungsform minimiert auf überraschend einfache Weise das Problem von Temperaturschwankungen der Wärmequelle.

Eine Variante der letztgenannten Ausführungsform weist einen Wärmetauscher mit zwei Kontaktelementen auf. Vorteilhafterweise können so zwei Wärmequellen über einen Wärmetauscher gekühlt werden.

Eine besonders bevorzugte Ausführungsform der erfindungsgemäßen Vorrichtung weist eine Serienschaltung mehrerer Reservoirs auf, wobei der Abfluss des i-ten Reservoirs den Zufluss des (i+1)-ten Reservoirs bildet. Ferner ist mindestens das letzte Reservoir in der Reihe mit einer Temperaturregelung/Pegelregelung ausgestattet. Eine Serienschaltung ist besonders vorteilhaft, da auf diese Weise mehrere Wärmequellen gekühlt werden können, ohne dass für jede einzelne eine separate Kühlvorrichtung vorhanden sein muss.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Kurze Beschreibung der Zeichnung

Es zeigen:
- Fig.1: Prinzipielle Funktionsweise eines Wärmetauschers
- Fig.2: Stand der Technik: Wärmetauscher mit schraubenartig gewundener Kühlleitung.
- Fig.3: Stand der Technik: Wärmetauscher mit zwei parallel geführten und spiralförmig gewundenen Kühlleitungen.
- Fig.4: Erfindungsgemäßer Wärmetauscher, bei dem die Wärmequelle mit der unteren Wand des Behälters thermisch gut leitend verbunden ist.
- Fig.5: Erfindungsgemäßer Wärmetauscher, bei dem die Wärmequelle mit der oberen Wand des Behälters thermisch gut leitend verbunden ist.
- Fig.6: Erfindungsgemäßer Wärmetauscher wie in Fig. 5, bei dem zudem eine Teilkomponente des Kontaktelementes vorhanden ist, welche im flüssigen Volumenanteil eingetaucht ist.
- Fig.7: Erfindungsgemäßer Wärmetauscher gemäß Fig.6 in 3D-Ansicht und mit teilweise entferntem Deckel.
- Fig.8: Erfindungsgemäßer Wärmetauscher ähnlich Fig.6, bei dem jedoch die Wärmequelle direkt mit dem Kontaktelement verbunden ist. Das Kontaktelement ist im flüssigen Volumenanteil eingetaucht.
- Fig.9: Erfindungsgemäßer Wärmetauscher gemäß Fig.6 mit einem Sensor, der beim Erreichen des Maximalpegels von V_{L} anspricht.
- Fig.10: Erfindungsgemäßer Wärmetauscher gemäß Fig.6 mit zwei Sensoren und, wobei ein Sensor bei Erreichen des Maximalpegels, und ein Sensor bei Erreichen des Minimalpegels von V_{L} anspricht.
- Fig.11: Erfindungsgemäßer Wärmetauscher gemäß Fig.6 mit einem Sensor zur Detektion des flüssigen Anteils F_{2L} in der Abflussleitung.
- Fig.12: Erfindungsgemäßer Wärmetauscher mit Temperatursensor und regelbarem Heizer, beide mit der Wärmequelle thermisch verbunden.
- Fig.13: Mehrere erfindungsgemäße und nebeneinander angeordnete Wärmetauscher, die seriell über Fluid transportierende Leitungen miteinander verbunden sind, wobei Pegelsensoren nur im letzten Wärmetauscher vorhanden sind
- Fig.14: Wie Fig. 13, aber mit untereinander angeordneten Wärmetauschern
- Fig.15: Wärmetauscher mit zwei Kontaktelementen, die an einem thermisch isolierenden Element befestigt sind
- Fig.16: Wärmetauscher mit einem Kontaktelement, welches an einem thermisch isolierenden Element befestigt ist, und dieses Element so ausgestaltet ist, dass die Kühlung des Kontaktelementes möglichst unabhängig vom Niveau des flüssigen Volumenanteils wird
- Fig.17: Wie Fig.16, aber mit zwei Kontaktelementen, die an zwei isolierenden Elementen befestigt sind.
- Fig.18: Kühlung eines NMR-Resonators mit Halterung und eines Signalverstärkers, ähnlich Fig.14.

### Bevorzugte Ausführungsformen der Erfindung,

Die erfindungsgemäße Vorrichtung soll in einer NMR-Detektionsvorrichtung den NMR-Resonator sowie diverse Bauelemente mittels Verdampfung eines kryogenen Fluids auf kryogene Temperaturen kühlen, den Einfluss von Vibrationen, die durch den Kühlvorgang entstehen können und störend auf das NMR-Signal wirken, weitgehend reduzieren, und insbesondere den Verbrauch des kryogenen Fluids so gering wie möglich halten.

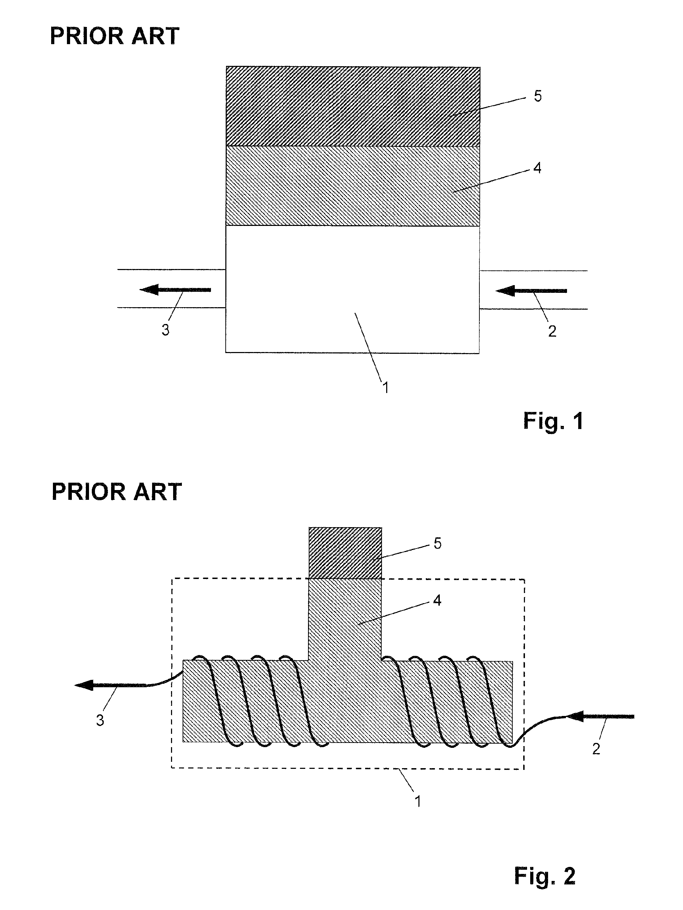

In Fig. 1 ist ein Wärmetauscher nach dem Stand der Technik dargestellt, mit einem **Wärmetauscher 1**, in den ein **Zufluss 2** an Kühlmittel zufließt und ein **Abfluss 3 an Kühlmittel** wieder abfließt. Eine **Wärmequelle 5** ist thermisch leitend fest mit einem **Kontaktelement 4** aus thermisch gut leitendem Material verbunden, welches den Wärmetransport von der Wärmequelle zum Wärmetauscher gewährleistet.

Eine weitere Ausführungsform des Stands der Technik ist in Fig. 2 dargestellt. Hier befindet sich das Kontaktelement 4 in T-förmiger Ausführung im Inneren des Wärmetauschers 1, während das Kühlmittel schraubenförmig um das Kontaktelement 4 geführt wird.

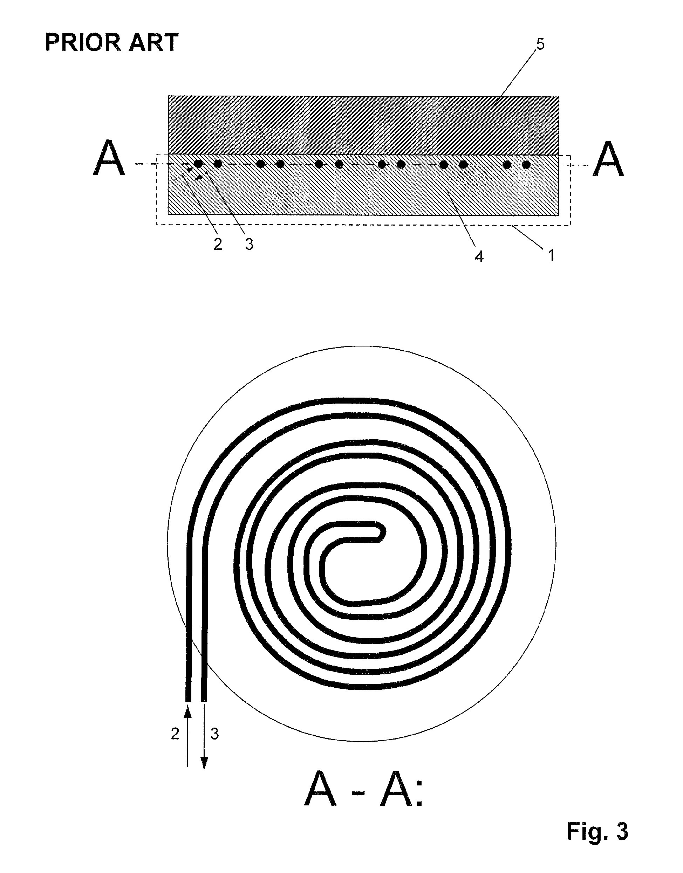

Fig. 3 zeigt eine andere Variante nach dem Stand der Technik, wobei hier das Kühlmittel spiralförmig horizontal zwischen der Wärmequelle 5 und dem Kontaktelement 4 eingebettet geführt wird.

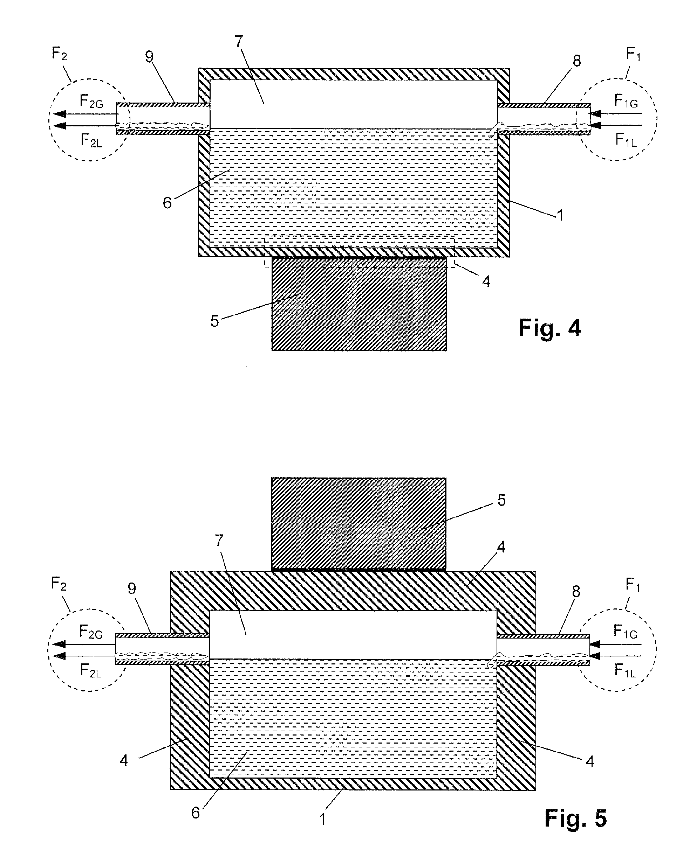

Der Grundaufbau der erfindungsgemäßen Kühlvorrichtung ist in Fig.4 dargestellt. Der als Behälter ausgeführte Wärmetauscher 1 besitzt im Inneren einen Raum mit einen **Volumenanteil an flüssigem Fluid V_{L} 6** und einen **Volumenanteil an gasförmigem Fluid V_{G} 7**, wobei die Räume von V_{L} 6 und V_{G} 7 mit einer **Zuflussleitung 8** und einer **Abflussleitung 9** in Verbindung stehen.

Über die Zuflussleitung 8 gelangt der Zufluss F₁ 2 an kryogenem Fluid in den Wärmetauscher 1. Der Zufluss F₁ 2 des kryogenen Fluids hat einen Flüssiganteil F_{1L} und einen Gasanteil F_{1G}.

Wenn sich die Wärmequelle 5 erwärmt, wird der von ihr ausgehende Wärmestrom über die dünn ausgeführte Wand des Wärmetauschers 1 direkt zum Volumenanteil flüssigen Kryogens V_{L} 6 im Innern des Wärmetauschers 1 übertragen. Hier verdampft unter Bildung von gasförmiger Phase eine gewisse Menge des Flüssiganteils V_{L} 6, wodurch dieser reduziert und der Gasanteil V_{G} 7 erhöht wird.

Das Ausmaß der Gasblasenbildung im flüssigen Volumenanteil V_{L} 6 kann gemäß der Siedelinie des kryogenen Fluids bestimmt werden, indem die für die Wärmeübertragung zur Verfügung stehende Fläche dem zu übertragenden Wärmestrom angepasst wird. Durch entsprechende Dimensionierung der Kontaktfläche zwischen thermischem Kontaktelement 4 und Flüssigkeitsanteil V_{L} 6 werden der Siedezustand im stationären Zustand und damit die Intensität der Gasblasenbildung bestimmt. Dadurch kann bereits bei der konstruktiven Auslegung einer erfindungsgemäßen Kühlvorrichtung zu intensives Blasensieden des Fluids in V_{L} 6 und damit die Entstehung von Vibrationen verhindert werden.

Im Gasraum V_{G} 7 im Innern des Wärmetauschers 1 sammeln sich die durch Verdampfung aus dem Flüssiganteil V_{L} 6 entstandenen Gase zusammen mit dem durch den Zufluss F₁ 2 eingebrachtem Gasanteil F_{1G}. Im Innern des Wärmetauschers 1 liegt zu jedem Zeitpunkt eine definierte Trennung zwischen gasförmiger Phase und flüssiger Phase vor.

Über die Abflussleitung 9 verlässt der Abfluss F₂ 3 des kryogenen Fluids den Wärmetauscher 1. Der Abfluss F₂ 3 des kryogenen Fluids hat einen Flüssiganteil F_{2L} und einen Gasanteil F_{2G}. Der Gasanteil F_{2G} des in F₂ 3 austretenden Fluids setzt sich zusammen aus dem Gasanteil F_{1G} des eintretenden Fluids zuzüglich der im Innern des Wärmetauschers 1 verdampften Menge aus dem Flüssiganteil V_{L} 6. Die Abflussleitung 9 ist im Verhältnis zur Zuflussleitung 8 so dimensioniert, dass die die Gasmenge F_{2G} abströmen kann, ohne zu Drückerhöhung im Innern des Wärmetauschers zu führen.

Hinsichtlich der Fördermenge an Flüssiganteil F_{1L} im stationären Zustand sind folgende Betriebszustände denkbar:
i) es wird genau soviel Flüssigkeit in den Wärmetauscher 1 hinein gefördert, wie zur Kühlung der Wärmequelle 5 verdampft werden muss.
ii) es wird mehr Flüssigkeit in den Wärmetauscher 1 hinein gefördert, wie zur Kühlung der Wärmequelle 5 verdampft werden muss.
iii) Es wird weniger Flüssigkeit in den Wärmetauscher 1 hinein gefördert, wie zur Kühlung der Wärmequelle 5 verdampft werden muss.

Bemerkungen zu den obigen drei Betriebszuständen:
i) Bei idealem Verhältnis zwischen zugeführtem Flüssiganteil F_{1L} und verdampfter Flüssigkeitsmenge liegt der Gasanteil F_{2G} in der Abflussleitung F₂ 9 bei 100%, d.h. es fließt keine überschüssige Flüssigkeit aus dem Innern des Wärmetauschers 1 heraus. Die Volumenanteile von Flüssigkeit V_{L} 6 und Gas V_{G} 7 im Innern des Wärmetauschers 1 bleiben zeitlich konstant.
ii) Wird durch den Zufluss F₁ 2 mehr Flüssigkeit F_{1L} zugeführt als im Innern des Wärmetauschers 1 im flüssigen Volumenanteil V_{L} 6 durch den Wärmestrom von der Wärmequelle 5 verdampfen muss, so bleiben die Volumenanteile von Flüssigkeit V_{L} 6 und Gas V_{G} 7 im Innern des Wärmetauschers 1 wie in Betriebszustand i) ebenfalls zeitlich konstant, weil durch die als Überlauf dienende Abflussöffnung 9 neben Gas auch Flüssigkeit ausfließt. Der durch die Abflussleitung 9 abfließende Abfluss F₂ 3 enthält in diesem Fall neben dem Gasanteil F_{2G} auch noch einen Flüssiganteil F_{2L}. Der Flüssiganteil F_{2L} des in F₂ 3 austretenden Fluids setzt sich dann zusammen aus dem Flüssiganteil F_{1L} des eintretenden Fluids abzüglich der in V_{L} 6 verdampften Menge. Dieser Betriebszustand ist denkbar, wenn der Wärmestrom reduziert wird oder im Zufluss F₁ 2 die Fördermenge erhöht wird
iii) Wird durch den Zufluss F₁ 2 weniger Flüssigkeit F_{1L} zugeführt als im Innern des Wärmetauschers 1 im flüssigen Volumenanteil V_{L} 6 durch den Wärmestrom von der Wärmequelle 5 verdampfen muss, so enthält Abfluss F₂ 3 zu 100 % Gasanteil F_{2G}. Der Flüssiganteils V_{L} 6 innerhalb des Wärmetauschers 1 wird dann reduziert, bis kein Flüssiganteil mehr vorhanden ist. Solange noch Flüssiganteil V_{L} 6 vorliegt kann der Wärmestrom noch abgeführt werden. Dieser Betriebszustand ist denkbar, wenn der Wärmestrom erhöht wird oder im Zufluss F₁ 2 die Fördermenge reduziert oder unterbrochen wird. Der flüssige Volumenanteil V_{L} 6 wirkt gewissermaßen als Puffer, damit Störungen in Form von nicht-konstanter Fördermenge in der Fluidförderung nicht an die Wärmequelle weitergeleitet werden. Ferner können dank dieser thermischen Pufferwirkung temporäre Erhöhungen des Wärmeeintrags ausgeglichen werden, ohne dass eine aktive Regelung notwendig wäre.

Neben dem Flüssiganteil dient auch der gasförmige Volumenanteil V_{G} 7 im Wärmetauscher 1 als Puffer resp. Dämpfungselement für Vibrationen.

Eine thermische annähernd ideale Isolation ist technisch äußerst aufwendig und für ein System inadäquat, dessen Hauptaugenmerk sich auf Wirtschaftlichkeit und geringe Betriebskosten richtet. Daher muss mit Wärmeeintrag aus der Umgebung resp. von den Leitungswänden gerechnet werden, welcher oft auch als thermischer Verlust beschrieben wird. Es kommt daher in der Förderleitung kryogener Flüssigkeiten zur Entstehung der Gasphase und demzufolge zur Ausbildung einer 2-Phasenströmung, die aus Anteilen von Gas und Flüssigkeit besteht. Die Gasanteile können als disperse Blasen in der Strömung vorliegen, aber sie können auch abschnittsweise den gesamten Querschnitt der Abflussleitung 9 einnehmen. Gasphase und Flüssigphase können sich mit unterschiedlichen Geschwindigkeiten bewegen und nehmen in unterschiedlichem Maße Wärme von den Wänden auf. Als Folge davon variiert der übertragbare Wärmestrom entlang einer Leitung, was besonders bei kryogenen Rohrwärmetauschern gemäß dem Stand der Technik zu schlecht definierter lokaler Wärmeübertragung führt. Es können instabile und instationäre Strömungszustände in der Zuflussleitung auftreten 8, die als thermoakustische Oszillationen durch das Leitungssystem wandern, bis sie aufgrund der Wandreibung oder durch geeignete konstruktive Maßnahmen abgedämpft werden.

Die quantitative Analyse solcher Effekte wäre in jedem Fall enorm aufwendig. Es liegt daher nahe, durch Vorsehen konstruktiver Elemente evtl. störende Auswirkungen dieser Effekte zu reduzieren. Ein solches konstruktives Element ist der gasförmige Volumenanteil V_{G} 7 im Inneren des Wärmetauschers 1, bzw. die Trennung des gasförmigen Anteils V_{G} 7 vom flüssigen Anteil V_{L} 6. Durch die Anordnung von Wärmequelle und Anpassung der Wandstärken ist gewährleistet, dass die Wärmeableitung von der Wärmequelle 5 stets über den Flüssiganteil V_{L} 6 erfolgt. Dadurch wird der Wärmestrom konstant stets durch Sieden übertragen. Eine gegebenenfalls zeitlich variable Wärmeübertragung durch Konvektion an den gasförmigen Anteil V_{G} 7 tritt zwar im oberen Bereich des Wärmetauscher 1 auf, ist im Vergleich zur Wärmeübertragung durch Sieden im flüssigen Anteil V_{G} 6 vernachlässigbar unter den Strömungsgeschwindigkeiten, die bei einer Kühlvorrichtung für Spulen-Resonatoren in NMR-Detektionsvorrichtungen vorherrschen würden. In der erfindungsgemäßen Kühlvorrichtung ist demnach die Position und das Ausmaß der Wärmeabgabe genau definiert und zeitlich konstant, da der Verdampfungsort, die wärmeübertragenden Kontaktflächen und der flüssige Volumenanteil V_{L} 6 zeitlich invariabel sind.

Druckvariationen, die aus den Leitungen in den Wärmetauscher 1 gelangen, bewirken eine minimale Kompression des im Verhältnis zum ankommenden Gasvolumen wesentlich größeren Rauminhalts. Durch die rasche Entlüftung gegen Atmosphäre durch die Abflussleitung 9 steht ferner ein noch größerer Puffer zur Verfügung, falls sich eine Druckvariation in der Abflussleitung 9 weiterhin fortsetzen sollte.

Der einzige Einfluss auf den Zustand des Flüssiganteils seitens der Umgebung beschränkt sich auf den Umgebungsdruck, dessen Variation zwar die Verdampfungstemperatur beeinflusst, aber verglichen mit der bei HF-Pulsen im **Resonator 16a** entstehenden Temperaturveränderung vernachlässigt werden kann. Falls die erwähnte Temperaturveränderung kompensiert werden soll, ist eine Ausführungsform der erfindungsgemäßen Vorrichtung denkbar, in der über eine Druckregelvorrichtung der Druck innerhalb des Wärmetauschers 1 konstant gehalten wird.

Der Wärmeübergang von dem thermischen Kontaktelement **4** zum flüssigen Volumenanteil V_{L} 6 ist wesentlich besser als zum gasförmigen Volumenanteil V_{G} 7. Wichtig für die vorliegenden Überlegungen ist, dass der Wärmestrom hauptsächlich an den flüssigen Volumenanteil V_{L} 6 abgegeben wird, und deshalb besondere Aufmerksamkeit dem bestmöglichen Transport der Wärmemenge von der Wärmequelle 5 hin zum flüssigen Volumenanteil V_{L} 6 hin gilt.

Fig.5 zeigt eine bevorzugte Ausführungsform der erfindungsgemäßen Kühlvorrichtung. Die Wärmequelle 5 ist hier mit der oberen Wand des Wärmetauschers 1 thermisch gut leitend verbunden. Bei dieser Ausführungsform erfüllen die obere Wand und die Seitenwände des Wärmetauschers 1 die Funktion eines thermischen Kontaktelements 4, so dass eine gute thermische Verbindung zwischen der Wärmequelle 5 und dem flüssigen Volumenanteil V_{L} 6 im Innern des Wärmetauschers 1 gewährleistet ist.

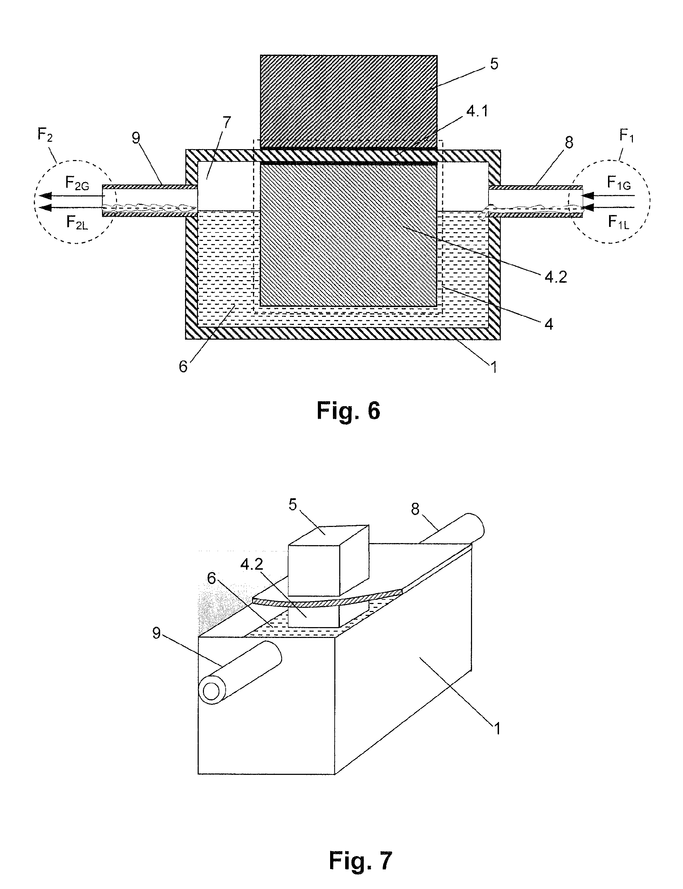

Fig.6 stellt eine weiter vorteilhafte Ausführungsform der erfindungsgemäßen Kühlvorrichtung dar, bei der die Wärmequelle 5 mit der oberen Wand des Behälters 1 thermisch gut leitend verbunden ist. Eine **Teilkomponente des Kontaktelements 4.1** ist auf der Außenseite des Behälters 1 thermisch gut leitend mit der Wärmequelle 5 verbunden. Eine **weitere Teilkomponente des Kontaktelements 4.2** steht im Innern des Behälters 1 in engem thermischen Kontakt mit dem flüssigen Volumenanteil V_{L} 6. Der Wärmestrom kann bei dieser Ausführungsform auf direktem Weg zum flüssigen Volumenanteil V_{L} 6 geführt werden, was sich in einem geringen Wärmewiderstand niederschlägt. Die Teilkomponente 4.2 im Innern des Behälters 1 ist derart angeordnet, dass der gasförmige Volumenanteil V_{G} 7 stets mit der Zuflussleitung 8 und der Abflussleitung 9 in Verbindung steht, wie in der räumlichen, teilweise aufgeschnittenen Ansicht in Fig.7 gezeigt ist.

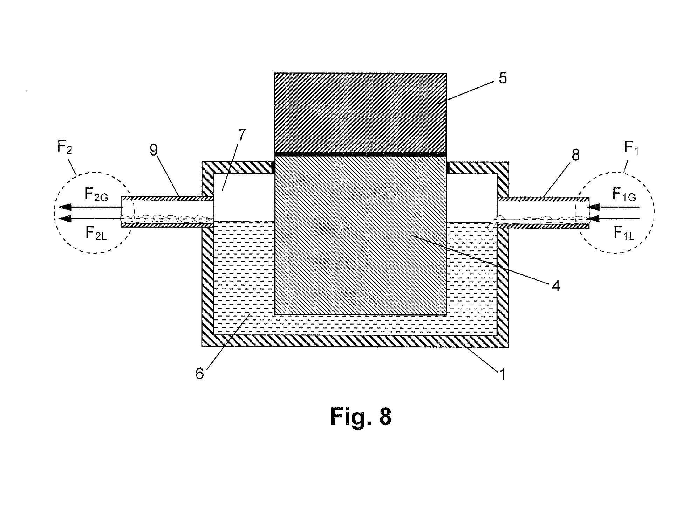

Fig.8 zeigt eine vorteilhafte Variante der in Fig. 6 dargestellten Ausführungsform. Das Kontaktelement 4 ist hier nicht mehr über die Wand des Behälters 1, sondern direkt mit der Wärmequelle 5 und dem flüssigen Volumenanteil V_{L} 6 thermisch gut leitend verbunden. Diese Ausführungsform bewirkt eine weitere Verringerung des Wärmewiderstands zwischen Wärmequelle 5 und flüssigem Volumenanteil V_{L} 6. Die Wand des Behälters 1 ist seitlich mit dem Kontaktelement 4 verbunden und dient hier nunmehr nur der mechanischen Befestigung. Hinsichtlich Wärmeübertragung zwischen Wärmequelle 5 und flüssigem Volumenanteil V_{L} 6 hat die Wand des Behälters 1 hier keine Funktion mehr.

In einer besonders vorteilhaften Ausführung verfügt die erfindungsgemäße Kühlvorrichtung über eine Regelvorrichtung zur Justierung des Fluid-Zuflusses F₁ 2. Ziel einer solchen Maßnahme ist es, den Fluidverbrauch dadurch zu minimieren, dass der Zufluss F₁ 2 in Abhängigkeit vom flüssigen Volumenanteil V_{L} 6 derart justiert wird, dass die im Abfluss F₂ 3 vorhandene Restmenge an Flüssigkeit F_{2F} verschwindend gering oder gleich Null ist.

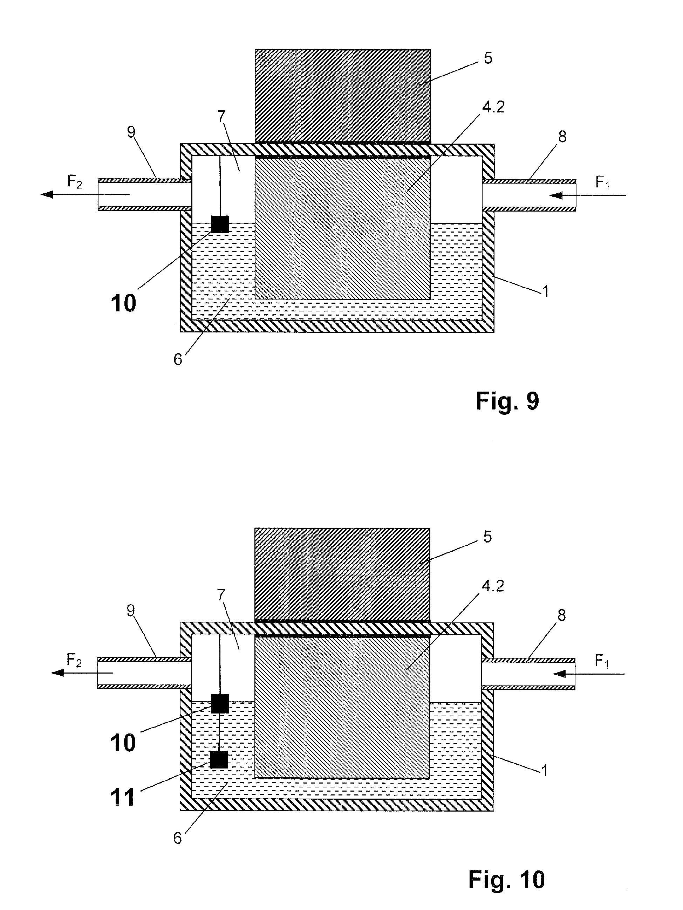

Eine Möglichkeit, die im Abfluss F₂ 3 vorhandene Restmenge an Flüssigkeit F_{2F} zu reduzieren, ist die Definition eines maximalen tolerierten Pegels des flüssigen Volumenanteils V_{L} 6 im Behälter 1, welcher durch die Einbauposition eines **Sensors 10** (siehe Fig. 9) definiert wird und unterhalb des Niveaus der Abflussöffnung 9 liegt.

Um auch den minimalem Pegel messen zu können, ist in einer besonders bevorzugten Ausführung (Fig.10) neben dem Sensor 10 zur Detektierung eines definierten maximal tolerierten Pegels zusätzlich ein **Sensor 11** zur Detektierung eines definierten minimalen tolerierten Pegels im Wärmetauscher 1 vorhanden.

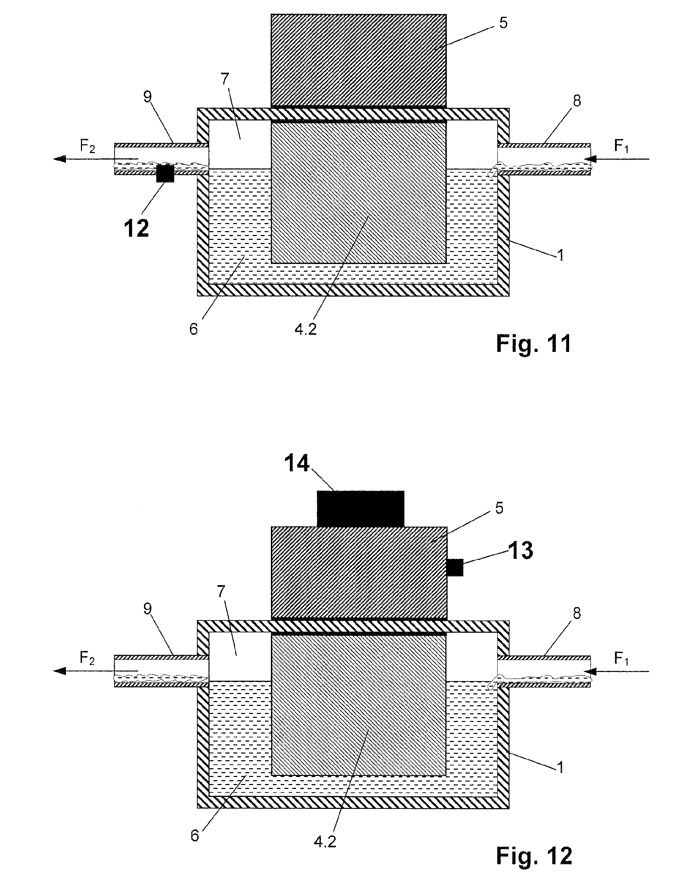

Eine alternative Ausführungsform ist in Fig.11 gezeigt. Diese Variante basiert auf der in Fig.6 beschriebenen Ausführung, die um einen **Sensor 12** in der Abflussöffnung 9 erweitert ist. Dieser Sensor 12 detektiert, ob im Abfluss F₂ 3 ein Flüssiganteil F_{2L} vorliegt. Ist der Flüssiganteil F_{2F} größer als Null, so wird die Regelvorrichtung den Zufluss F₁ 2 reduzieren.

Eine weitere mögliche Ausführungsform ist in Fig.12 gezeigt. Hier befindet sich an der Wärmequelle 5 ein **Sensor 13** und ein **Heizer 14**. Der Sensor 13 misst die Temperatur an der Wärmequelle 5. Weicht die gemessene Temperatur von einem definierten Sollwert ab, so wird über die Regelvorrichtung durch Erhöhen oder Reduzieren der Heizleistung am Heizer 14 die Temperaturänderung ausgeglichen. Die Regelvorrichtung, der Sensor 13 und der Heizer 14 können derart konfiguriert werden, dass im Wärmetauscher 1 stets der gleiche Wärmestrom übertragen wird und stets die gleiche Menge an Flüssiganteil V_{L} 6 verdampft. Diese Variante kann besonders vorteilhaft mit den Ausführungsformen gemäß Fig.9, Fig.10 und Fig.11 kombiniert werden.

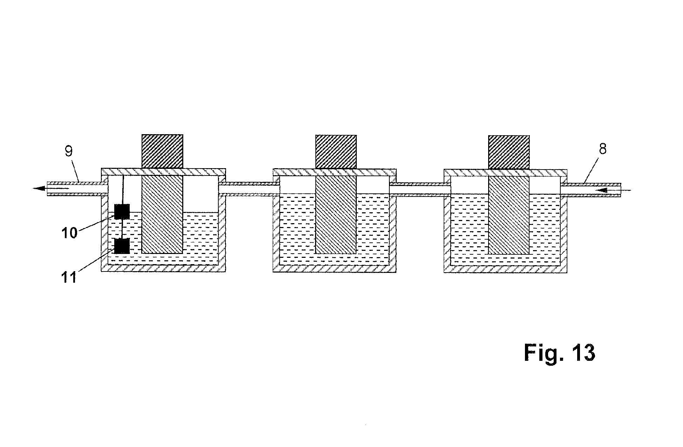

In Fig.13 sind mehrere erfindungsgemäße Wärmetauscher seriell nebeneinander angeordnet und jeweils über Fluid-führende Leitungen verbunden. Der Pegel des Flüssiganteils V_{L} 6 in jedem einzelnen Wärmetauscher 1 der seriellen Anordnung ist maximal, so dass im Abfluss F₂ 3 jedes Wärmetauschers genügend Flüssiganteil F_{2L} vorliegt, um in den nachfolgenden Wärmetauschern ausreichend Flüssiganteil V_{L} 6 zu gewährleisten. Der letzte Wärmetauscher in Durchflussrichtung einer seriellen Anordnung kann über eine Regelvorrichtung beispielsweise aus Fig.9, Fig.10, Fig.11 oder einer daraus abgeleiteten Regelvorrichtung verfügen, um den Fluidverbrauch zu minimieren. In der Ausführungsform gemäß Fig.13 befinden sich beispielhaft im letzten Wärmetauscher in Durchflussrichtung ein Sensor 10 zur Detektion eines maximal tolerierten Pegels von V_{L} 6 und ein Sensor 11 zur Detektion eines minimal tolerierten Pegels von V_{L} 6, in Anlehnung an die Variante in Fig.10.

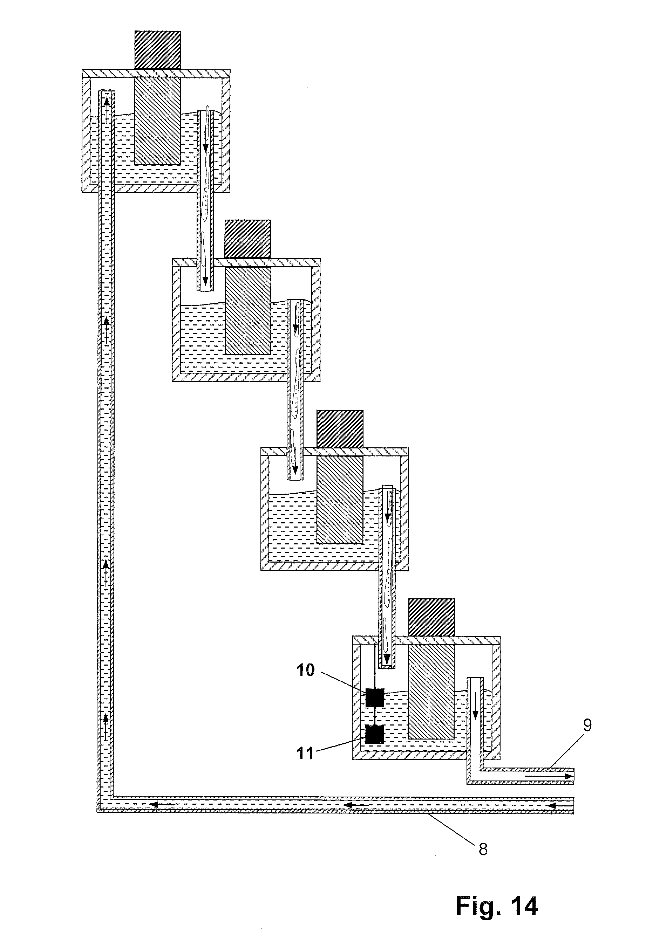

Eine weitere serielle Anordnung ist in Fig.14 gezeigt, in der mehrere übereinander angeordnete Wärmetauscher über Fluid führende Leitungen miteinander verbunden sind und im letzten Wärmetauscher der Anordnung mit Sensoren 10 und 11 zur Detektion eines maximalen bzw. minimalen Pegels von V_{L} 6 ausgestattet sind.

Je nach räumlichen Gegebenheiten einer Anwendung sind beliebige Kombinationen aus serieller und paralleler Anordnung denkbar.

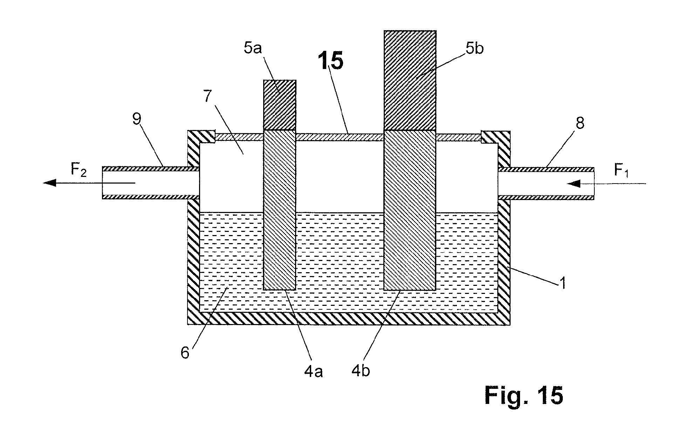

Eine besonders vorteilhafte Ausführungsform ist in Fig.15 gezeigt. Hier sind zwei **separate Wärmequellen 5a und 5b** mit ebenfalls **separaten thermisch gut leitenden Kontaktelementen 4a und 4b** verbunden, die beide in einem Wärmetauscher 1 in denselben Flüssiganteil V_{L} 6 eingetaucht sind. Die beiden thermisch gut leitenden Kontaktelemente 4a und 4b sind über **thermisch isolierende Befestigungselemente 15a** und **15b** mit der Wand des Wärmetauschers 1 verbunden.

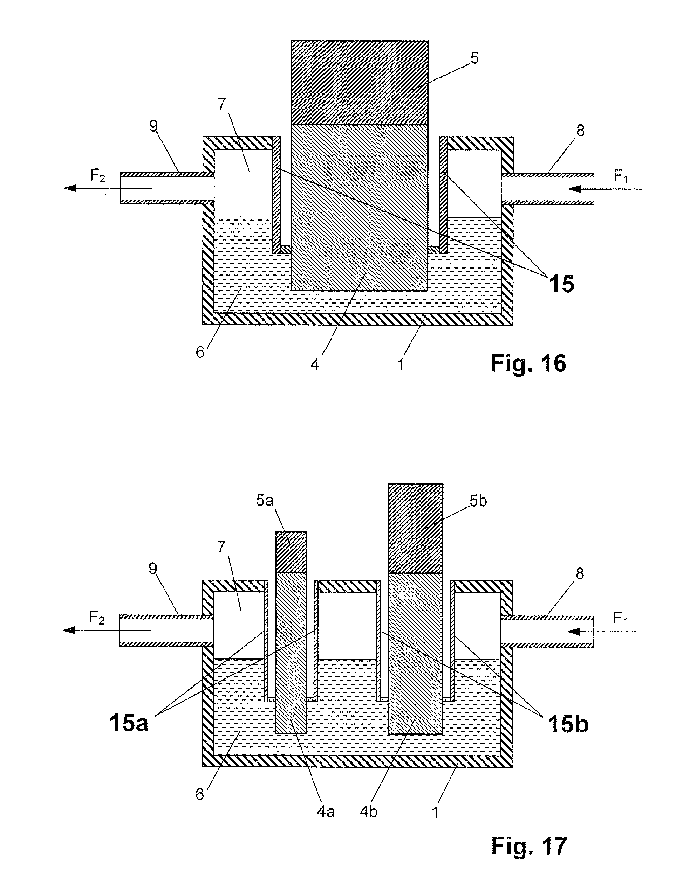

Fig.16 zeigt eine Ausführungsform der erfindungsgemäßen Vorrichtung mit nur einem thermisch isolierenden **Befestigungselement 15**. Das Befestigungselement 15 ist an der Wand des Wärmetauscher 1 befestigt, und wird dann als mäanderförmige Fortsetzung der Wärmetauscherwand in den Innenraum des Wärmetauschers 1 hineingeführt und dort mit den Kontaktelementen 4a und 4b verbunden. Der Ort der Kontaktierung von isolierendem Befestigungselement 15 und Kontaktelement 4 liegt unterhalb der Zuflussleitung 8 und unterhalb der Abflussleitung 9, so dass der Pegel des Flüssiganteils V_{L} 6 stets oberhalb des Ortes der Kontaktierung liegt. Bei Veränderungen des Pegels von V_{L} 6 bleiben in dieser Konfiguration die Kontaktfläche zwischen Flüssiganteil V_{L} 6 und Kontaktelement 4, sowie die Distanz zwischen Wärmequelle 5 und Kontaktfläche konstant.

Fig.17 zeigt eine Kombination der Ausführungsformen gemäß Fig.15 und Fig.16. In dieser Variante werden zwei thermisch voneinander entkoppelte Wärmequellen 5a und 5b über zwei separate Kontaktelemente 4a und 4b mit demselben Flüssiganteil V_{L} 6 verbunden und mittels zweier separater thermisch isolierender Befestigungselemente 15a und 15b an der Wand des Wärmetauschers 1 befestigt. Diese Variante ermöglicht das gleichzeitige Kühlen zweier Wärmequellen 5a und 5b bei gleichzeitiger thermischer Entkopplung, sowie Entkopplung vom Pegel des Flüssiganteils V_{L} 6.

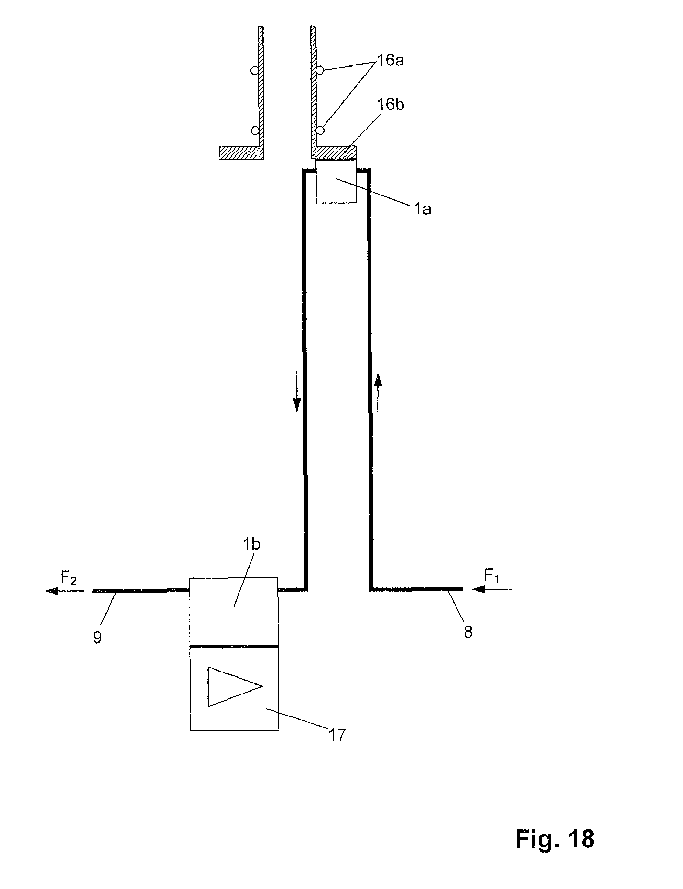

Namentlich werden die HF-Resonatoren 16a mitsamt **Halterung 16b,** oder die HF-Resonatoren 16a zusammen mit dem **Signalverstärker 17** in einem NMR-Probenkopf gekühlt (Fig.18). Dabei können zuerst die Resonatoren 16a und anschließend der Signalverstärker 17 mit Fluid versorgt werden, oder umgekehrt.

HF-Resonatoren und Signalverstärker wirken jeweils als eine Wärmequelle. Die thermische Last infolge von HF-Pulssequenzen wird vom einem kryogenen Fluid aufgenommen, indem der flüssige Anteil verdampft.

### Bezugszeichenliste

- 1: Wärmetauscher resp. Behälter des Wärmetauschers
- 1a: Wärmetauscher zur Kühlung des NMR-Resonators
- 1b: Wärmetauscher zur Kühlung des NMR-Signalverstärkers
- 2: Zufluss F₁ des kryogenen Fluids mit den Anteilen F_{1L} und F_{1G}, wobei F_{1L} der flüssige und F_{1G} der gasförmige Anteil bedeuten
- 3: Abfluss F₂ des kryogenen Fluids mit den Anteilen F_{2L} und F_{2G}, wobei F_{2L} der flüssige und F_{2G} der gasförmige Anteil bedeuten
- 4, 4a, 4b: Thermisch gut leitendes Kontaktelement in verschiedenen Ausführungsformen
- 4.1: Teilkomponente des Kontaktelementes
- 4.2: eine weitere Teilkomponente des Kontaktelementes
- 5, 5a, 5b: Die zu kühlende Wärmequelle
- 6: Flüssiger Volumenanteil V_{L} des kryogenen Fluids im Behälter
- 7: Gasförmiger Volumenanteil V_{G} des kryogenen Fluids im Behälter
- 8: Zuflussleitung für F₁
- 9: Abflussleitung für F₂
- 10: Sensor zur Detektierung des maximal erwünschten Pegels des flüssigen Volumenanteils V_{L}
- 11: Sensor zur Detektierung des minimal erwünschten Pegels des flüssigen Volumenanteils V_{L}
- 12: Sensor zur Detektierung des flüssigen Anteils F_{2L} in der Abflussleitung 9
- 13: Temperatursensor an der Wärmequelle 5
- 14: Heizer zur Regelung der Temperatur der Wärmequelle 5
- 15, 15a, 15b: Thermisch isolierendes Befestigungselement für die Kontaktelemente
- 16a: HF-Resonator
- 16b: Halterung des HF-Resonators
- 17: Signalverstärker

## Patentansprüche

1. Kryo-Probenkopfkopf zum Senden und/oder Empfangen von Hochfrequenz (=HF)-Signalen für Kernspinresonanz(=NMR)-Messungen, mit mindestens einem Wärmetauscher (1; 1 a, 1 b) zur Kühlung einer oder mehrerer Wärmequellen (5), insbesondere Bauelementen des Kryo-Probenkopfes, wobei dem Wärmetauscher (1; 1 a, 1 b) kryogenes Fluid zugeführt wird und der Wärmetauscher (1; 1 a, 1 b) mindestens ein Kontaktelement (4; 4.1, 4.2; 4a, 4b) aufweist, das eine thermisch gut leitende Verbindung zwischen dem kryogenen Fluid und der Wärmequelle (5) gewährleistet,
**dadurch gekennzeichnet,**
**dass** der Wärmetauscher (1; 1 a, 1 b) einen als Pufferreservoir für das kryogene Fluid wirkenden Behälter mit einem Innenvolumen V_{B} umfasst, welcher eine erste Öffnung aufweist, durch die über eine Zuflussleitung (8) des Wärmetauschers
ein erstes kryogenes Fluid F₁ hineinfließen kann, das einen flüssigen Anteil
F_{1L} und einen gasförmigen Anteil F_{1G} aufweist, und welcher eine zweite Öffnung aufweist, durch welche über eine Abflussleitung (9) des Wärmetauschers ein zweites
kryogenes Fluid F₂ herausfließen kann, das einen flüssigen Anteil F_{2L} und
einen gasförmigen Anteil F_{2G} aufweist,
**dass** die Zuflussleitung (8) einen Durchflussquerschnitt Q_{Z} und einen Umfang U_{Z} aufweist, aus denen sich ein hydraulischer Durchmesser D_{hyd,Z}=4·Q_{Z}/U_{Z} und daraus ein charakteristisches Leitungsvolumen V_{Z}=Q_{Z}·D_{hyd,Z} ergibt, wobei der Behälter im Verhältnis zur Zuflussleitung (8) so beschaffen ist, dass V_{B}>10·V_{Z},
**dass** die Abflussleitung (9) einen Durchflussquerschnitt Q_{A} aufweist, der so gewählt ist, dass Q_{A}≥Q_{Z},
**dass** das Kontaktelement (4; 4.1; 4.2; 4a, 4b) sowohl mit dem flüssigen Volumenanteil V_{L} des kryogenen Fluids im Behälter als auch mit der Wärmequelle (5) in engem thermischen Kontakt steht,
**dass** die Öffnungen der Zuflussleitung (8) und der Abflussleitung (9) so weit oberhalb der unteren Wand des Behälters angeordnet sind, dass der flüssige Volumenanteil VL nicht vollständig aus dem Behälter abfließen kann, und
**dass** eine Vorrichtung zur Einstellung der Zuflussmenge des ersten kryogenen Fluids F₁ in den Behälter vorgesehen ist, die es ermöglicht, dass im Betrieb des Kryo-Probenkopfes ein Zustand erreicht und gehalten wird, bei welchem gilt: F_{1L}/ F_{1G} > F_{2L}/F_{2G}.

2. Kryo-Probenkopf nach Anspruch 1, **dadurch gekennzeichnet, dass** der Behälter und die Zuflussleitung (8) so gestaltet sind, dass gilt V_{B}>20·V_{Z}, vorzugsweise 70·V_{Z}≤ V_{B}≤150·V_{Z}.

3. Kryo-Probenkopf nach einem der vorgehenden Ansprüche, **dadurch gekennzeichnet, dass** ein Sensor (10; 11; 12) zur Detektierung des aktuellen Pegelstands des Volumenanteils V_{L} an flüssigem kryogenen Fluid im Behälter oder zur Detektierung des flüssigen Anteils F_{2L} in der Abflussleitung (9) vorgesehen ist, und
dass eine Regelvorrichtung vorgesehen ist, welche die Vorrichtung zur Einstellung der Zuflussmenge des ersten kryogenen Fluids F₁ in den Behälter ansteuert und den Volumenanteil V_{L} an flüssigem kryogenen Fluid im Behälter im Verhältnis zum Volumenanteil V_{G} an gasförmigem kryogenen Fluid auf einen vorgebbaren Wert regelt.

4. Kryo-Probenkopf nach Anspruch 3, **dadurch gekennzeichnet, dass** die Vorrichtung zur Einstellung der Zuflussmenge des ersten kryogenen Fluids F₁ in den Behälter so eingerichtet ist, dass der Fluidzufluss erhöht wird, sobald die Unterschreitung eines vorgebbaren Pegelstands gemeldet wird.

5. Kryo-Probenkopf nach Anspruch 3, **dadurch gekennzeichnet, dass** die Vorrichtung zur Einstellung der Zuflussmenge des ersten kryogenen Fluids F₁ in den Behälter so eingerichtet ist, dass der Fluidzufluss bei Erreichen oder Überschreiten eines maximalen Flüssigkeitspegels verringert, vorzugsweise abgesperrt und bei Erreichen oder Unterschreiten eines minimalen Flüssigkeitspegels der Fluidzufluss wieder zugeschaltet bzw. vergrößert wird.

6. Kryo-Probenkopf nach einem der vorhergehenden Ansprüche, **dadurch gekennzeichnet, dass** eine Temperaturregelung der Wärmequelle (5) mit Hilfe einer Regelvorrichtung und eines mit der Wärmequelle (5) thermisch gut verbunden Heizers (14) vorgesehen ist.

7. Kryo-Probenkopf nach einem Ansprüche 1 bis 6, **dadurch gekennzeichnet, dass** die Wärmequelle (5) an der unteren Wand des zum Wärmetauscher (1) gehörenden Behälters befestigt ist, wobei diese untere Wand die Funktion des Kontaktelementes (4) übernimmt und deshalb vorzugsweise aus einem Material mit einem möglichst kleinen thermischen Widerstand und einer Wandstärke, die möglichst klein ist, aufgebaut ist.

8. Kryo-Probenkopf nach einem der Ansprüche 1 bis 5, **dadurch gekennzeichnet, dass** die Wärmequelle (5) an der oberen Wand des zum Wärmetauscher (1) gehörenden Behälters befestigt ist, wobei die obere und die seitlichen Wände dieses Behälters die Funktion des Kontaktelementes (4) übernehmen und deshalb vorzugsweise aus einem Material mit einem möglichst kleinen thermischen Widerstand und einer Wandstärke, die möglichst groß ist, aufgebaut sind.

9. Kryo-Probenkopf nach Anspruch 8, **dadurch gekennzeichnet, dass** ein Wärmetauscher (1) mit zwei oder mehr Kontaktelementen (4a, 4b) ausgestattet ist.

10. Kryo-Probenkopf nach einem der Ansprüche 1 bis 6, **dadurch gekennzeichnet, dass** die Wärmequelle (5) an der oberen Wand des zum Wärmetauscher (1) gehörenden Behälters befestigt ist, und dieser Behälter zudem in seinem Innern ein thermisch gut leitendes Kontaktelement (4) enthält, das mit der oberen Wand des Behälters fest verbunden und in das flüssige Fluid V_{L} eingetaucht ist, wobei das Kontaktelement (4) vorzugsweise direkt unterhalb der Wärmequelle (5) angeordnet ist und die obere Wand vorzugsweise eine möglichst kleine Wandstärke besitzt.

11. Kryo-Probenkopf nach einem der Ansprüche 1 bis 6, **dadurch gekennzeichnet, dass** der Wärmetauscher (1) mit einem Kontaktelement (4) ausgestattet ist, das oben aus dem Wärmetauscher (1) ragt, an der oberen Wand des Wärmetauschers (1) befestigt ist und eine gute thermische Verbindung zur Wärmequelle (5) besitzt, wobei der untere Teil vom Kontaktelement (4) im flüssige Fluid V_{L} eingetaucht ist, so dass auf diese Weise eine möglichst gute thermische Verbindung zwischen der Wärmequelle (5) und dem flüssigen Fluid V_{L} gewährleistet ist.

12. Kryo-Probenkopf nach einem Ansprüche 1 bis 6, **dadurch gekennzeichnet, dass** das Kontaktelement (4; 4a, 4b) mit einem thermisch isolierenden Befestigungselement (15; 15a, 15b) verbunden ist, und dieses Befestigungselement (15; 15a, 15b) derart gestaltet ist, dass der obere Teil des Kontaktelements (4; 4a, 4b) vom flüssigen Fluid V_{L} abgetrennt wird, und nur der untere Teil im Fluid V_{L} eingetaucht bleibt.

13. Kryo-Probenkopf nach einem der Ansprüche 1 bis 6, **dadurch gekennzeichnet, dass** die Wärmequelle an der seitlichen Wand des zum Wärmetauscher gehörenden Behälters oberhalb des Fluidpegels befestigt ist, wobei diese Wand die Funktion des Kontaktelementes übernimmt und deshalb vorzugsweise aus einem Material mit einem möglichst kleinen thermischen Widerstand und einer Wandstärke, die möglichst groß ist, aufgebaut ist.

14. Kryo-Probenkopf nach einem der Ansprüche 1 bis 6, **dadurch gekennzeichnet, dass** die Wärmequelle an der seitlichen Wand des zum Wärmetauscher gehörenden Behälters unterhalb des Fluidpegels befestigt ist, wobei diese Wand die Funktion des Kontaktelementes übernimmt und deshalb vorzugsweise aus einem Material mit einem möglichst kleinen thermischen Widerstand und einer Wandstärke, die möglichst klein ist, aufgebaut ist.

## Claims

1. A cryo probe head for the transmission and/or reception of radiofrequency (=RF) signals for nuclear magnetic resonance (=NMR) measurements, with at least one heat exchanger (1; 1a, 1b) for cooling one or more heat sources (5), in particular, components of the cryo probe head, wherein a cryogenic fluid is supplied to the heat exchanger (1; 1a, 1b) and the heat exchanger (1; 1a, 1b) has at least one contact element (4; 4.1, 4.2; 4a, 4b) that ensures a connection with good thermal conduction between the cryogenic fluid and the heat source (5),
**characterized in that**
the heat exchanger (1; 1a, 1b) comprises a container acting as a buffer reservoir for the cryogenic fluid with an interior volume V_{B}, the container comprising a first opening through which a first cryogenic fluid F₁ that has a liquid fraction F_{1L} and a gaseous fraction F_{1G} enters through an inflow conduit (8) of the heat exchanger, and a second opening through which a second cryogenic fluid F₂ that has a liquid fraction F_{2L} and a gaseous fraction F_{2G} flows out through an outflow conduit (9) of the heat exchanger,
the inflow conduit (8) has a flow cross-section Q_{Z} and a circumference U_{Z} from which a hydraulic diameter D_{hyd,Z}=4·Q_{Z}/U_{Z} and, from this, a characteristic conduit volume V_{Z}=Q_{Z}·D_{hyd,Z} results, wherein the container is constituted in relation to the inflow conduit (8) in such a way that V_{B}> 10·V_{Z},
the outflow conduit (9) has a flow cross-section Q_{A} that is chosen such that Q_{A}≥Q_{Z},
the contact element (4; 4.1; 4.2; 4a, 4b) is in close thermal contact with both the liquid volume fraction V_{L} of the cryogenic fluid in the container and with the heat source (5),
the openings of the inflow conduit (8) and of the outflow conduit (9) are disposed that far above the lower wall of the container such that the liquid volume fraction VL cannot completely flow out of the container, and
a device for setting the inflow quantity of the first cryogenic fluid F₁ into the container is provided that enables a state to be reached and maintained during operation of the cryo probe head at which the following applies: F_{1L}/F_{1G} > F_{2L}/F_{2G}.

2. Cryo probe head according to claim 1, **characterized in that** the container and the inflow conduit (8) are constituted such that V_{B}>20·V_{Z}, preferably 70·V_{Z}≤V_{B}≤150·V_{Z}, applies.

3. Cryo probe head according to any one of the previous claims, **characterized in that** a sensor (10; 11; 12) is provided for detecting the current level of the volume fraction V_{L} of liquid cryogenic fluid in the container or for detecting the liquid fraction F_{2L} in the outflow conduit (9), and
a control device is provided that controls the device for setting the inflow quantity of the first cryogenic fluid F₁ into the container and controls the volume fraction V_{L} of liquid cryogenic fluid in the container in relation to the volume fraction V_{G} of gaseous cryogenic fluid at a definable value.

4. Cryo probe head according to claim 3, **characterized in that** the device for setting the inflow quantity of the first cryogenic fluid F₁ into the container is adapted such that the fluid inflow is increased as soon as a settable level is fallen below and this is signaled.

5. Cryo probe head according to claim 3, **characterized in that** the device for setting the inflow quantity of the first cryogenic fluid F₁ into the container is adapted such that the fluid inflow is reduced, preferably blocked, when a maximum liquid level is reached or exceeded and the fluid inflow is opened or increased again when a minimum liquid level is reached or fallen below.

6. Cryo probe head according to any one of the previous claims **characterized in that** a temperature control of the heat source (5) is provided by means of a control device and a heater that is thermally well connected to the heat source (5).

7. Cryo probe head according to any one of the claims 1 to 6, **characterized in that** the heat source (5) is connected to the lower wall of the container belonging to the heat exchanger (1), wherein this lower wall performs the function of the contact element (4) and therefore is preferably made of a material with the lowest possible thermal resistance and a wall thickness that is as small as possible.

8. Cryo probe head according to any one of the claims 1 to 5, **characterized in that** the heat source (5) is connected to the upper wall of the container belonging to the heat exchanger (1), wherein the upper wall and the side walls of this container perform the function of the contact element (4) and therefore preferably consist of a material with the lowest possible thermal resistance and a wall thickness that is as large as possible.

9. Cryo probe head according to claim 8, **characterized in that** a heat exchanger (1) is equipped with two or more contact elements (4a, 4b).

10. Cryo probe head according to any one of the claims 1 to 6 **characterized in that** the heat source (5) is connected to the upper wall of the container belonging to the heat exchanger (1) and this container also contains in its interior a contact element (4) with good thermal conduction that is permanently connected to the upper wall of the container and is immersed in the liquid fluid V_{L}, wherein the contact element (4) is preferably arranged directly below the heat source (5) and the upper wall preferably has the smallest possible wall thickness.

11. Cryo probe head according to any one of the claims 1 to 6, **characterized in that** the heat exchanger (1) is equipped with a contact element (4) that protrudes from the top of the heat exchanger (1), is attached to the upper wall of the heat exchanger (1), and has a good thermal connection to the heat source (5), wherein the lower part of the contact element (4) is immersed in the liquid fluid V_{L} so that the best possible thermal connection between the heat source (5) and the liquid fluid V_{L} is thereby ensured.

12. Cryo probe head according to any one of the claims 1 to 6, **characterized in that** the contact element (4; 4a, 4b) is connected to a thermally insulating fastening element (15; 15a, 15b) and this fastening element (15; 15a, 15b) is constituted such that the upper part of the contact element (4; 4a, 4b) is separated from the liquid fluid V_{L} and only the lower part remains immersed in the fluid V_{L}.

13. Cryo probe head according to any one of the claims 1 to 6, **characterized in that** the heat source is attached above the fluid level to the side wall of the container belonging to the heat exchanger, wherein this wall performs the function of the contact element and is therefore preferably made from a material with the lowest possible thermal resistance and a wall thickness that is as large as possible.

14. Cryo probe head according to any one of the claims 1 to 6, **characterized in that** the heat source is attached below the fluid level to the side wall of the container belonging to the heat exchanger, wherein this wall performs the function of the contact element and therefore is preferably made of a material with the lowest possible thermal resistance and a wall thickness that is as small as possible.

## Revendications

1. Tête de mesure cryogénique pour envoyer et/ou recevoir des signaux à haute fréquence (= HF) pour des mesures de résonance magnétique nucléaire (= RMN), avec au moins un échangeur de chaleur (1 ; 1a, 1b) pour refroidir une ou plusieurs sources de chaleur (5), en particulier des composants de la tête de mesure cryogénique, un fluide cryogénique étant amené à l'échangeur de chaleur (1 ; 1a, 1b) et l'échangeur de chaleur (1 ; 1a, 1b) présentant au moins un élément de contact (4 ; 4.1, 4.2 ; 4a, 4b) qui garantit une liaison à bonne conductibilité thermique entre le fluide cryogénique et la source de chaleur (5),
**caractérisée en ce**
**que** l'échangeur de chaleur (1 ; 1a, 1b) comprend un récipient ayant un volume intérieur V_{B} et faisant office de réservoir tampon pour le fluide cryogénique, lequel présente une première ouverture à travers laquelle un premier fluide cryogénique F₁, qui présente une fraction liquide F_{1L} et une fraction gazeuse F_{1G}, peut entrer via une conduite d'amenée (8) de l'échangeur de chaleur, et lequel présente une deuxième ouverture à travers laquelle un deuxième fluide cryogénique F₂, qui présente une fraction liquide F_{2L} et une fraction gazeuse F_{2G}, peut sortir via une conduite d'évacuation (9),
**que** la conduite d'amenée (8) présente une section de passage Q_{Z} et un périmètre U_{Z} dont il résulte un diamètre hydraulique D_{hyd,Z} = 4·Q_{Z}/U_{Z} et de celui-ci un volume de conduite caractéristique V_{Z} = Q_{Z}·D_{hyd,Z}, le récipient étant conçu par rapport à la conduite d'amenée (8) de façon que V_{B} > 10·V_{Z},
**que** la conduite d'évacuation (9) présente une section de passage Q_{A} qui est choisie de façon que Q_{A} ≥ Q_{Z},
**que** l'élément de contact (4 ; 4.1 ; 4.2 ; 4a, 4b) est en étroit contact thermique aussi bien avec la fraction de volume liquide V_{L} du fluide cryogénique dans le récipient qu'avec la source de chaleur (5),
**que** les ouvertures de la conduite d'amenée (8) et de la conduite d'évacuation (9) sont disposées assez loin au-dessus de la paroi inférieure du récipient pour que la fraction de volume liquide V_{L} ne puisse pas s'écouler entièrement du récipient, et qu'un dispositif pour régler l'afflux du premier fluide cryogénique F₁ dans le récipient est prévu, qui permet, pendant le fonctionnement de la tête de mesure cryogénique, d'atteindre et de maintenir un état dans lequel : F_{1L}/F_{1G} > F_{2L}/ F_{2G}.

2. Tête de mesure cryogénique selon la revendication 1, **caractérisée en ce que** le récipient et la conduite d'amenée (8) sont conçus de façon que V_{B} > 20·V_{Z}, de préférence 70·V_{Z} ≤ V_{B} ≤ 150·V_{Z}.

3. Tête de mesure cryogénique selon l'une des revendications précédentes, **caractérisée en ce qu'**un capteur (10 ; 11 ; 12) pour détecter le niveau actuel de la fraction volumique V_{L} de fluide cryogénique liquide dans le récipient ou pour détecter la fraction liquide F_{2L} dans la conduite d'évacuation (9) est prévu, et qu'un dispositif de régulation est prévu, lequel commande le dispositif de réglage de l'afflux du premier fluide cryogénique F₁ dans le récipient et régule la fraction volumique V_{L} de fluide cryogénique liquide dans le récipient par rapport à la fraction volumique V_{G} de fluide cryogénique gazeux à une valeur prédéfinissable.

4. Tête de mesure cryogénique selon la revendication 3, **caractérisée en ce que** le dispositif de réglage de l'afflux du premier fluide cryogénique F₁ dans le récipient est conçu de façon à augmenter l'amenée de fluide dès que le dépassement vers le bas d'un niveau prédéfinissable est signalé.

5. Tête de mesure cryogénique selon la revendication 3, **caractérisée en ce que** le dispositif de réglage de l'afflux du premier fluide cryogénique F₁ dans le récipient est conçu de façon à diminuer, de préférence interrompre, l'amenée de fluide en cas d'atteinte ou de dépassement d'un niveau de liquide maximum et à reprendre ou augmenter l'amenée de fluide en cas d'atteinte ou de dépassement vers le bas d'un niveau de liquide minimum.

6. Tête de mesure cryogénique selon l'une des revendications précédentes, **caractérisée en ce qu'**une régulation de température de la source de chaleur (5) à l'aide d'un dispositif de régulation et d'un élément de chauffage (14) présentant une bonne liaison thermique avec la source de chaleur (5) est prévue.

7. Tête de mesure cryogénique selon l'une des revendications 1 à 6, **caractérisée en ce que** la source de chaleur (5) est fixée à la paroi inférieure du récipient faisant partie de l'échangeur de chaleur (1), cette paroi inférieure assumant la fonction de l'élément de contact (4) et étant pour cela constituée de préférence d'un matériau ayant une résistance thermique aussi petite que possible et une épaisseur de paroi aussi petite que possible.

8. Tête de mesure cryogénique selon l'une des revendications 1 à 5, **caractérisée en ce que** la source de chaleur (5) est fixée à la paroi supérieure du récipient faisant partie de l'échangeur de chaleur (1), la paroi supérieure et les parois latérales de ce récipient assumant la fonction de l'élément de contact (4) et étant pour cela constituées de préférence d'un matériau ayant une résistance thermique aussi petite que possible et une épaisseur de paroi aussi grande que possible.

9. Tête de mesure cryogénique selon la revendication 8, **caractérisée en ce qu'**un échangeur de chaleur (1) est équipé de deux ou plusieurs éléments de contacts (4a, 4b).

10. Tête de mesure cryogénique selon l'une des revendications 1 à 6, **caractérisée en ce que** la source de chaleur (5) est fixée à la paroi supérieure du récipient faisant partie de l'échangeur de chaleur (1), et ce récipient contient en outre dans son intérieur un élément de contact (4) ayant une bonne conductibilité thermique, qui est assemblé rigidement avec la paroi supérieure du récipient et immergé dans le fluide liquide V_{L}, l'élément de contact (4) étant de préférence disposé directement sous la source de chaleur (5) et la paroi supérieure possédant de préférence une épaisseur de paroi aussi petite que possible.

11. Tête de mesure cryogénique selon l'une des revendications 1 à 6, **caractérisée en ce que** l'échangeur de chaleur (1) est équipé d'un élément de contact (4) qui dépasse en haut de l'échangeur de chaleur (1), est fixé à la paroi supérieure de l'échangeur de chaleur (1) et possède une bonne liaison thermique avec la source de chaleur (5), la partie inférieure de l'élément de contact (4) étant immergée dans le fluide liquide V_{L}, de sorte qu'une liaison thermique aussi bonne que possible est assurée de cette façon entre la source de chaleur (5) et le fluide liquide V_{L}.

12. Tête de mesure cryogénique selon l'une des revendications 1 à 6, **caractérisée en ce que** l'élément de contact (4 ; 4a, 4b) est relié à un élément de fixation isolant thermiquement (15 ; 15a, 15b), et cet élément de fixation (15 ; 15a, 15b) est conçu de façon que la partie supérieure de l'élément de contact (4 ; 4a, 4b) soit séparée du fluide liquide V_{L} et que seule la partie inférieure reste immergée dans le fluide V_{L}.

13. Tête de mesure cryogénique selon l'une des revendications 1 à 6, **caractérisée en ce que** la source de chaleur est fixée au-dessus du niveau de fluide à la paroi latérale du récipient faisant partie de l'échangeur de chaleur, cette paroi assumant la fonction de l'élément de contact et étant pour cela constituée de préférence d'un matériau ayant une résistance thermique aussi petite que possible et une épaisseur de paroi aussi grande que possible.

14. Tête de mesure cryogénique selon l'une des revendications 1 à 6, **caractérisée en ce que** la source de chaleur est fixée au-dessous du niveau de fluide à la paroi latérale du récipient faisant partie de l'échangeur de chaleur, cette paroi assumant la fonction de l'élément de contact et étant pour cela constituée de préférence d'un matériau ayant une résistance thermique aussi petite que possible et une épaisseur de paroi aussi petite que possible.
